# EUROPÄISCHE PATENTSCHRIFT

(11) **EP 3 486 671 B1**
(45) Veröffentlichungstag und Bekanntmachung des Hinweises auf die Patenterteilung: **24.06.2020**
(21) Anmeldenummer: 18206517.7
(22) Anmeldetag: 15.11.2018
(51) Int. Cl.: G01R 33/30

(54) **MAS-NMR-PROBENKOPFANORDNUNG MIT AUSWECHSELBAREM STATOR**
MAS-NMR SAMPLE HEAD ARRANGEMENT WITH REPLACEABLE STATOR
DISPOSITIF DE TÊTE D'ÉCHANTILLON RMN POUR MAS À STATOR INTERCHANGEABLE

(30) Priorität: 20.11.2017 DE 102017220707
(43) Veröffentlichungstag der Anmeldung: 22.05.2019
(73) Patentinhaber: Bruker Switzerland AG, 8117 Fällanden (CH)
(72) Erfinder: Freytag, Nicolas, 8122 Binz (CH); Kühler, Fabian, 8603 Schwerzenbach (CH); Osen, David, 76275 Ettlingen (DE)
(74) Vertreter: Kohler Schmid Möbus Patentanwälte

(56) Entgegenhaltungen:
- US-B1- 6 320 384
- US-B2- 7 196 521
- US-B2- 7 915 893
- JAMES N. LEE ET AL: "Cylindrical spinner and speed controller for magic angle spinning nuclear magnetic resonance", REVIEW OF SCIENTIFIC INSTRUMENTS, Bd. 55, Nr. 4, April 1984 (1984-04), Seite 516, XP055122569, ISSN: 0034-6748, DOI: 10.1063/1.1137783
- MUELLER K T ET AL: "Dynamic-angle spinning of quadrupolar nuclei", JOURNAL OF MAGNETIC RESONANCE, ACADEMIC PRESS, LONDON, GB, Bd. 86, Nr. 3, 15. Februar 1990 (1990-02-15), Seiten 470-487, XP023956496, ISSN: 0022-2364, DOI: 10.1016/0022-2364(90)90025-5 [gefunden am 1990-02-15]

## Beschreibung

Die Erfindung betrifft eine MAS-NMR-Probenkopfanordnung, umfassend einen an einer Rotationsachse ausgerichteten Stator zur Lagerung eines Rotors mit einer Messsubstanz, eine Stator-Halterung, und eine HF-Spulenanordnung zum Einstrahlen von HF-Pulsen in die Messsubstanz im Rotor und/oder zum Empfangen von HF-Signalen aus der Messsubstanz im Rotor, wobei der Stator im eingeführten Zustand die HF-Spulenanordnung durchragt.

Eine solche MAS-NMR-Probenkopfanordnung ist aus der US 7,915,893 B2 bekannt geworden.

Kernspinresonanz(=NMR, nuclear magnetic resonance)-Spektroskopie ist ein leistungsfähiges Verfahren der instrumentellen Analytik, mit der die chemische Zusammensetzung von Messsubstanzen (Proben) untersucht werden kann. Dabei wird die Messsubstanz einem starken, statischen Magnetfeld ausgesetzt, wodurch es zur Ausrichtung von Kernspins in der Messsubstanz kommt. Nach Einstrahlung von HF(=Hochfrequenz)-Pulsen werden von der Messsubstanz ausgehende HF-Signale aufgenommen und zur Bestimmung der chemischen Zusammensetzung ausgewertet.

Bei der NMR-Spektroskopie von Festkörperproben kommt es zu einer erheblichen Linienverbreiterung in gemessenen NMR-Spektren aufgrund von anisotropen Wechselwirkungen zwischen Kernen in der Probe. Für Festkörperproben ist es bekannt, die Messsubstanz während der NMR-Messung unter dem so genannten "Magischen Winkel" von ca. 54,7° gegen die Richtung des statischen Magnetfelds zu rotieren (MAS, "magic angle spinning"). Dadurch kann eine Linienverbreiterung durch dipolare Wechselwirkungen, Quadrupolwechselwirkungen und den anisotropen Teil der chemischen Verschiebung reduziert bzw. bei ausreichend hohen Rotationsfrequenzen ausgelöscht werden.

Die Messsubstanz wird hierfür typischerweise in ein im Wesentlichen zylindrisches Probenröhrchen, genannt Rotor, gefüllt und in einen Stator verbracht. Der Rotor wird relativ zum Stator in Rotation versetzt, wobei der Rotor im Stator schwebt; hierfür werden geeignete Gasströme eingesetzt. Um HF-Pulse in die Messsubstanz einzustrahlen und/oder HF-Signale aus der Messsubstanz zu empfangen, ist eine HF-Spulenanordnung vorgesehen, die den Stator umgibt.

Aus der US 7,915,893 B2 ist ein Stator bekannt geworden, der mit einer Gehäuseröhre und einer inneren Hülse ausgebildet ist. In der inneren Hülse ist ein Rotor angeordnet. In die innere Hülse sind bei gleichen Radien Düsenaustrittsöffnungen für zwei Lager ausgebildet, die auf den Rotor gerichtet sind. Eines der Lager wirkt mit einem zylinderförmigen Abschnitt des Rotors zusammen, und das andere der Lager wirkt mit einem konischen Endteil des Rotors zusammen. Der Stator ist von einer Solenoidspule und einem keramischen Spulenformkörper umgeben, wobei der Stator den keramischen Spulenformkörper durchragt. Der Stator ist beidenends mit Verteilerringen verklebt oder verlötet, die einen gleichen Durchmesser aufweisen wie der keramische Spulenformkörper. Aufgrund der festen Verbindung des Stators mit den Verteilerringen ist der Stator dauerhaft in dem keramischen Spulenformkörper angeordnet. Daher kann im Falle eines Defekts am Stator dieser nur zusammen mit dem keramischen Spulenformkörper und der Solenoidspule ausgetauscht werden. Dies ist ein aufwändiges und teures Vorgehen. Eine weitere Bauform mit fest verbautem Stator ist aus der US 7,282,919 B2 bekannt geworden.

Aus der US 2016/0334478 A1 ist ein NMR-MAS-Probenkopf mit Rotor und Stator bekannt geworden, wobei zwei pneumatische Radiallager und ein Bodenlager ausgebildet sind. Zwischen den statorseitigen Teilen der Radiallager kann eine HF-Spulenanordnung angeordnet werden. Der Rotor ist zylinderförmig, mit gleichen Radien an beiden Radiallagern. Ebenso weisen die Düsenaustrittsöffnungen im Stator an beiden Radiallagern den gleichen Radius auf. Bei dieser Bauform kann bei einem Defekt am Stator der Probenkopf teilweise zerlegt werden, und ein Statorteil kann in radialer Richtung ausgebaut werden. Dies ist jedoch sehr aufwändig. Bei zwischen den statorseitigen Teilen der Radiallager angeordneter HF-Spulenanordnung ist es nicht möglich, den Stator in axialer Richtung ein- oder auszuführen. Ähnliche Anordnungen sind aus der DE 10 2013 201 110 B3 und der US 7,196,521 B2 bekannt geworden.

Aus der US 8,212,565 B2 und der US 4,511,841 ist es bekannt geworden, eine HF-Spule in radialer Richtung in eine Öffnung im Stator einzuführen. Bei der US 6,320,384 B1 und der US 6,803,764 B2 wird die HF-Spule in eine Statorstruktur eingeführt und von dieser umbaut. Zweigeteilte Statoren, die von beiden Seiten montiert werden, sind aus der US 9,335,389 und der US 2010 / 0 321 018 A1 bekannt geworden.

### Aufgabe der Erfindung

Der Erfindung liegt die Aufgabe zugrunde, eine MAS-NMR-Probenkopfanordnung bereitzustellen, mit der eine verbesserte Montage- und Wartungsfreundlichkeit erreicht werden kann.

### Kurze Beschreibung der Erfindung

Diese Aufgabe wird auf überraschend einfache und wirkungsvolle Weise gelöst durch eine MAS-NMR-Probenkopfanordnung der eingangs genannten Art, die dadurch gekennzeichnet ist,
dass die Stator-Halterung mit einem Stator-Lager ausgebildet ist, in das der Stator axial ein- und ausführbar ist,
wobei der Stator zum Ein- und Ausführen durch die HF-Spulenanordnung hindurchführbar ist, und wobei die Probenkopfanordnung Mittel umfasst, mit denen der Stator im eingeführten Zustand im Stator-Lager temporär axial fixierbar ist, und dass die Stator-Halterung einen axialen Anschlag ausbildet, der eine maximal axial eingefahrene Position des Stators in der Stator-Halterung definiert.

Im Rahmen der Erfindung ist es vorgesehen, den Stator und die Stator-Halterung bzw. die MAS-NMR-Probenkopfanordnung so auszubilden, dass der Stator in das Stator-Lager in axialer Richtung (entlang der Rotationsachse des Rotors im Falle des Normalbetriebs) eingeschoben oder auch herausgezogen werden kann. Dadurch kann der Stator leicht montiert und etwa für Wartungszwecke demontiert werden. Der Ein- und Ausbau in axialer Richtung ist sehr viel einfacher möglich als etwa in radialer Richtung, insbesondere ohne aufwändige Zerlegung der MAS-NMR-Probenkopfanordnung. Zudem kann ein allfälliger Austausch des Stators auf den Stator selbst beschränkt werden; weitere Bauteile des MAS-NMR-Probenkopfs (insbesondere eine HF-Spulenanordnung) brauchen grundsätzlich nicht mit ausgetauscht zu werden. Ggf. kann jedoch das Lösen und Wiederherstellen von Gasleitungen (für Antrieb und/oder Lagerung und/oder Temperierung) erforderlich sein, was jedoch einen lediglich geringen Aufwand darstellt.

Der Stator ist in der Stator-Halterung bzw. im Stator-Lager axial beweglich gelagert und im eingeführten Zustand mechanisch reversibel bzw. temporär axial fixierbar, typischerweise durch eine Klemmung oder eine Verspannung. Eine axiale Fixierung des Stators kann insbesondere durch einen Formschluss (mit einem axial hintergreifenden Sicherungsteil) und/oder einen Kraftschluss (mit einem radial andrückenden Sicherungsteil) erfolgen. Es genügt, wenn die axiale Fixierung den üblicherweise im Normalbetrieb (Messbetrieb) auftretenden Kräften gut standhalten kann, aber durch eine größere Kraft überwunden werden kann. Eine einfache axiale Fixierung des Stators kann beispielsweise über elastische Elemente, insbesondere Dichtungsringe, erfolgen, die radial auf den Stator drücken, und insbesondere den Stator umgreifen.

Das Stator-Lager legt den Stator im eingeführten Zustand radial und bevorzugt auch bezüglich einer Drehstellung um die Rotationsachse fest. Der Stator ist im normalen Betrieb im eingeführten Zustand, das heißt im Stator-Lager angeordnet; in diesem Zustand können Rotoren in den Stator eingeführt (und ausgeführt) werden, um jeweils enthaltene Messsubstanz zu vermessen.

Der Stator kann bei installierter HF-Spulenanordnung bei der Montage oder zu Wartungszwecken an der Probenkopfanordnung als Ganzes ein- und ausgeführt werden, und insbesondere aus der Probenkopfanordnung entfernt werden. Dann können beispielsweise Reinigungsarbeiten am Stator (etwa bei freigesetzter Messsubstanz infolge zerbrochener Rotoren) leichter durchgeführt werden, und beschädigte Statoren können leichter ersetzt werden, insbesondere ohne Ausbau der HF-Spulenanordnung.

### Bevorzugte Ausführungsformen der Erfindung

Eine bevorzugte Ausführungsform der erfindungsgemäßen Probenkopfanordnung sieht vor,
dass der Stator eine erste Lagerbasis, ein Hüllelement und eine zweite Lagerbasis umfasst, wobei das Hüllelement die erste Lagerbasis und die zweite Lagerbasis axial miteinander verbindet, und wobei die erste Lagerbasis ein erstes pneumatisches Lager ausbildet, und die zweite Lagerbasis ein zweites pneumatisches Lager ausbildet,
dass die zweite Lagerbasis einen größten Außendurchmesser AD2 aufweist, dass das Hüllelement einen vorderen Abschnitt aufweist, der sich an die zweite Lagerbasis axial anschließt und einen größten Außendurchmesser ADV aufweist,
dass die HF-Spulenanordnung einen kleinsten Innendurchmesser IDS aufweist, und dass AD2 < IDS und weiterhin ADV < IDS.

Diese Bauform stellt auf einfache Weise sicher, dass ein vorderer Teil des Stators in und durch die HF-Spulenanordnung hindurch passt. Im eingeführten Zustand durchragt der Stator die HF-Spulenanordnung typischerweise mit dem vorderen Abschnitt des Hüllelements und der zweiten Lagerbasis. Diese Bauform hat sich in der Praxis besonders bewährt. Durch den kleineren Außendurchmesser von zweiter Lagerbasis und vorderem Abschnitt des Hüllelements (also einem gesamten vorderen Teil des Stators) gegenüber dem Innendurchmesser der HF-Spulenanordnung ist ein Hindurchführen des Stators durch die HF-Spulenanordnung leicht möglich. Der vordere Abschnitt hat typischerweise eine Länge LV, mit LV ≥ 0,5 * LS, oder auch LV ≥ 1,0*LS, mit LS: Länge der HF-Spulenanordnung (im Falle mehrerer geschachtelter Teilspulen bezogen auf eine innerste Teilspule). Typischerweise ragt der Stator bis unmittelbar vor das erste pneumatische Lager in die HF-Spulenanordnung hinein. Mit dem Hüllelement können zum einen Gasströmungen zwischen Rotor und Stator gestaltet werden, und zum anderen können innerhalb und/oder außerhalb des Stators bzw. Hüllelements Räume unter besonderen Bedingungen, etwa mit besonderen Temperaturen oder Druckverhältnissen, eingerichtet werden, um für eine MAS-NMR-Messung gezielte, insbesondere optimierte, Bedingungen einzurichten. Zudem kann mittels des verbindenden Hüllelements ein als Ganzes handhabbares Stator-Bauteil eingerichtet werden.

Bei einer bevorzugten Weiterbildung dieser Ausführungsform weist die erste Lagerbasis und/oder das Hüllelement im Bereich der ersten Lagerbasis einen größten Außendurchmesser AD1 auf, und AD1 > IDS. Die erste Lagerbasis kann in dieser Ausführungsform einen größeren radialen Raum nutzen als es innerhalb oder jenseits der HF-Spulenanordnung (für die zweite Lagerbasis) möglich ist. Entsprechend kann ein besonders robustes und lagersteifes erstes pneumatisches Lager eingerichtet werden.

Vorteilhaft ist auch eine Weiterbildung, bei der die Stator-Halterung eine erste Dichtung aufweist, mit der die erste Lagerbasis und/oder das Hüllelement im Bereich der ersten Lagerbasis gegenüber der Stator-Halterung gasdicht abgedichtet wird. Ebenso vorteilhaft ist eine Weiterbildung, bei der die Stator-Halterung eine zweite Dichtung aufweist, mit der die zweite Lagerbasis und/oder das Hüllelement im Bereich der zweiten Lagerbasis gegenüber der Stator-Halterung gasdicht abgedichtet wird. Insbesondere können auch erste und zweite Dichtung zusammen eingesetzt werden. Die Dichtungen können Gasströme etwa für Antrieb, Lagerung oder Temperierung einrichten und führen, und voneinander getrennte Gasräume schaffen, etwa zur gezielten Temperierung eines oder mehrerer Bereiche der Probenkopfanordnung. Die Dichtungen bestehen typischerweise aus einem Elastomer, etwa Gummi. Zudem können die Dichtungen zur axialen Fixierung des Stators dienen oder beitragen.

Besonders bevorzugt ist eine Weiterbildung, bei der das Hüllelement gasdicht ausgebildet ist. Dadurch kann das Hüllelement besonders gut dazu beitragen, Gasströme am Rotor und/oder Stator zu leiten und voneinander separate Gasräume einzurichten, um für MAS-NMR-Messungen optimierte Bedingungen einzurichten. Insbesondere kann der Rotor unabhängig von der HF-Spulenanordnung temperiert werden; beispielsweise kann der Rotor bzw. die Messsubstanz gekühlt werden.

Bevorzugt ist weiterhin eine Weiterbildung, bei der die Probenkopfanordnung im eingeführten Zustand des Stators einen gasdichten Raum ausbildet, der durch das Hüllelement mit begrenzt wird, und in welchem die HF-Spulenanordnung angeordnet ist. Das Hüllelement dient dann nicht nur als Strukturbauteil, das die Lagerbasen miteinander verbindet, um den Stator als Ganzes handhabbar zu machen, sondern (im eingeführten Zustand) auch als Trennwand zum gasdichten Raum der HF-Spulenanordnung. Dadurch kann in radialer Richtung ein besonders kompakter Bau erreicht werden. Zudem ist es möglich, die HF-Spulenanordnung gezielt speziellen Bedingungen auszusetzen, insbesondere anderen Bedingungen als den Bedingungen am Rotor oder in der Umgebung des Probenkopfs (auch genannt Probenkopfanordnung), um die MAS-NMR-Messung zu optimieren.

Besonders bevorzugt ist es dabei, wenn der gasdichte Raum evakuiert ist. Dadurch kann die HF-Spulenanordnung thermisch sehr gut isoliert werden.

Vorteilhaft ist es auch, wenn die HF-Spulenanordnung im gasdichten Raum auf eine kryogene Temperatur T gekühlt ist, bevorzugt mit T ≤ 100 K, besonders bevorzugt mit T ≤ 40 K oder T ≤ 20 K. Durch eine kryogene Temperatur der HF-Spulenanordnung kann das Signal-zu-Rausch-Verhältnis einer MAS-NMR-Messung verbessert werden. Man beachte, dass der Raum um den Rotor herum (insbesondere im Stator) typischerweise auf Raumtemperatur ist (alternativ kann der Rotor bzw. die Messsubstanz auch mittels Gasströmen gezielt temperiert werden).

Bevorzugt ist es auch, wenn ein den Rotor umgebender Raum, insbesondere innerhalb des Stators, auf eine Temperatur T_{R} gekühlt ist, bevorzugt mit T_{R} ≤ 300 K, besonders bevorzugt mit T_{R} ≤ 100 K oder T_{R} ≤ 20 K. Durch die kühlende Temperierung können Prozesse in der Messprobe, etwa Spinrelaxationen, beeinflusst, insbesondere verlangsamt werden, um für die MAS-NMR-Messung gewünschte Bedingungen einzustellen. Die Kühlung erfolgt typischerweise durch das Antriebsgas und/oder das Lagergas. Hingegen ist der gasdichte Raum, in dem die HF-Spulenanordnung angeordnet ist, typischerweise auf Raumtemperatur (alternativ kann auch im gasdichten Raum bzw. an der HF-Spulenanordnung eine andere Temperatur gezielt eingestellt werden).

Bevorzugt ist eine Steuereinrichtung vorhanden, mit der ein den Rotor umgebender Raum, insbesondere innerhalb des Stators, bezüglich der Temperatur T_{R} in einem Temperaturbereich eingestellt werden kann, bevorzugt mit -0°C ≤ T_{R} ≤ 80°C, besonders bevorzugt mit -40°C ≤ T_{R} ≤ 150°C. Dieser Temperaturbereich ist für biologische Messproben besonders relevant, insbesondere kann eine Denaturierung von Proteinen vermieden werden, wenn die Rotortemperatur im Betrieb unterhalb der Denaturierungstemperatur gehalten werden kann.

Bevorzugt ist weiterhin eine Ausführungsform, bei der die Mittel, mit denen der Stator im eingeführten Zustand im Stator-Lager axial fixierbar ist, ein bewegliches oder abnehmbares Sicherungsteil umfassen, das in einer sichernden Stellung den Stator axial hintergreift, insbesondere wobei das bewegliche oder abnehmbare Sicherungsteil am Stator im Bereich der ersten Lagerbasis angreift. Durch einen axialen Hintergriff kann eine besonders zuverlässige axiale Fixierung erreicht werden. Typischerweise wird der Stator durch das Sicherungsteil (in der sichernden Stellung) auch in axialer Richtung an der (übrigen) Stator-Halterung elastisch verspannt, um ein axiales Spiel zu vermeiden. Das Sicherungsteil wird (in der sichernden Stellung) meist an der (übrigen) Stator-Halterung verschraubt. In einer nicht sichernden Stellung (etwa zurückgezogen, weggeklappt oder abgehoben) ist der axiale Verfahrweg für den Stator frei, etwa für eine Entnahme des Stators. Am axial hintergreifenden Sicherungsteil kann ein elastisches Element angeordnet sein, das axial auf den Stator drückt. Alternativ kann ein bewegliches Sicherungsteil auch in einer sichernden Stellung radial auf den Stator drücken, etwa mit einem elastischen Element (z.B. mit einem Elastomer-Körper oder einer Feder), um diesen im Kraftschluss zu fixieren; das bewegliche Sicherungsteil kann beispielsweise als Schraubbolzen ausgebildet sein, an dessen vorderem Ende das elastische Element angeordnet ist.

Vorteilhaft ist eine Ausführungsform, bei der die Mittel, mit denen der Stator im eingeführten Zustand im Stator-Lager axial fixierbar ist, wenigstens ein stationäres Sicherungsteil umfassen, wobei das stationäre Sicherungsteil mit einem elastischen Element ausgebildet ist, das im eingeführten Zustand des Stators in radialer Richtung auf den Stator drückt, insbesondere wobei zwei stationäre Sicherungsteile vorgesehen sind, die als Dichtungsringe ausgebildet sind. Ein (bezüglich der Stator-Halterung) stationäres Sicherungsteil ist besonders einfach anzuordnen. Das wenigstens eine stationäre Sicherungsteil sichert den Stator im eingeführten Zustand durch Kraftschluss. Die Haltekraft reicht aus, um den Stator im Normalbetrieb (Messbetrieb) axial fixiert zu halten. Für die Montage oder Wartung kann der Stator jedoch - gegen die Haltekraft - in axialer Richtung ins Stator-Lager ein- und ausgeführt werden. Das elastische Element besteht typischerweise aus Elastomermaterial, insbesondere für die Verwendung bei Temperaturen über 150°C aus Fluorelastomeren und für die Verwendung unter -40°C aus Silikonkautschuk oder Fluorsilikonkautschuk.

Alternativ kann das elastische Element auch aus einem wenig elastischen Material wie z.B. PTFE oder einer Kombination aus einem wenig elastischen Material und Vorspannelementen, z.B. in Form von Federn realisiert werden. Mit Dichtungsringen kann zusätzlich zur axialen Sicherung eine Gasabdichtung erfolgen, etwa um einen evakuierten Raum für die HF-Spulenanordnung einzurichten.

Bevorzugt ist weiterhin eine Ausführungsform, bei der der axiale Anschlag mit einer Schulter des Stators zusammenwirkt, die durch die erste Lagerbasis oder das Hüllelement in einem Bereich, der die erste Lagerbasis umgreift, ausgebildet ist. Durch den Anschlag kann auf einfache Weise die axiale Position des Stators und damit auch eines in diesem angeordneten Rotors (mit) definiert werden. Typischerweise wird der Stator mittels der Mittel zum axialen Fixieren gegen den Anschlag gedrückt. Durch die Ausbildung einer Schulter an der ersten Lagerbasis oder am Hüllelement in einem Bereich, der die erste Lagerbasis umgreift, wird das in die HF-Spulenanordnung einführbare Probenvolumen nicht beeinträchtigt, so dass besonders große Probenvolumen genutzt werden können.

Bevorzugt ist weiterhin eine Ausführungsform, die vorsieht, dass das erste pneumatische Lager und das zweite pneumatische Lager dazu ausgebildet sind, einen Rotor im Stator radial zu lagern,
und dass in den Stator ein Rotor eingeführt ist, welcher im Bereich des ersten pneumatischen Lagers an einem kreiszylinderförmigen Abschnitt des Rotors eine erste Lagerfläche bei einem Radius R1 ausbildet, und welcher im Bereich des zweiten pneumatischen Lagers eine zweite Lagerfläche bei einem Radius R2 ausbildet. Die beiden pneumatischen Lager halten den Stator in radialer Richtung in Position ("Radiallager"). Man beachte, dass die zweite Lagerfläche an einer kreiszylinderförmigen Fläche (insbesondere an einem Endabschnitt) oder auch an einer konischen Fläche (insbesondere an einem Endabschnitt) des Rotors liegen kann. Der Radius Ri der Lagerflächen bezieht sich auf die Position mittig bezüglich der zugehörigen Düsenaustrittsöffnungen im Stator; im Falle von mehreren Düsenaustrittsöffnungen an verschiedenen axialen Positionen bezieht sich der Radius der Lagerflächen auf einen mittlere axiale Position der Düsenaustrittsöffnungen. Entsprechendes gilt für die Radien ri von Düsenaustrittsöffnungen am Stator.

### Weiterbildung mit am vorderen Ende verengtem Rotor

Besonders bevorzugt ist eine Weiterbildung hierzu, mit R2 < R1, insbesondere wobei weiterhin AD2=ADV. Durch die engere Ausbildung der vorderen, zweiten Lagerfläche mit Radius R2 gegenüber der hinteren, ersten Lagerfläche bzw. dem kreiszylinderförmigen Abschnitt des Rotors mit Radius R1 wird ein radialer Raum für die Ausbildung des zweiten Lagers (Radiallagers) bzw. dessen statorseitigen Teil zur Verfügung gestellt. Entsprechend kann das zweite Lager statorseitig enger ausgebildet werden als das erste Lager.

Man beachte, dass das zweite Lager hier an einem Endabschnitt des Rotors ausgebildet ist, der einen gegenüber dem kreiszylinderförmigen Abschnitt kleineren oder weg vom kreiszylindrischen Abschnitt sich verkleinernden Radius aufweist.

Ein dieser Weiterbildung entsprechendes MAS-NMR-Rotorsystem, umfassend Rotor und Stator, kann dann einenends (vorne, im Bereich des zweiten pneumatischen Lagers) radial enger ausgebildet werden als anderenends (hinten, im Bereich des ersten pneumatischen Lagers). Dadurch kann das Rotorsystem gut mit dem vorderen Ende (umfassend den Endabschnitt und zumindest einen Teil des kreiszylinderförmigen Abschnitts) in einen radial begrenzten Raum eingeführt werden, in welchen das hintere Ende (mit dem ersten pneumatischen Lager) nicht mehr hineinpassen würde.

Durch die erfindungsgemäße Geometrie kann eine HF-Spulenanordnung (ein HF-Spulensystem), in das der Stator und der Rotor in axialer Richtung eingeführt werden, sehr nahe an den Rotor bzw. die Messsubstanz heranrücken. Das nutzbare Volumen für Messsubstanz im Inneren der HF-Spulenanordnung wird nicht durch die radiale Breite des am kreiszylinderförmigen Abschnitt wirkenden ersten pneumatischen Lagers, sondern nur durch die radiale Breite des am radial kleineren Endabschnitt angeordneten, zweiten pneumatischen Lagers (oder durch den kreiszylinderförmigen Abschnitt selbst, sollte dieser eine größere radiale Breite aufweisen) bestimmt. Insgesamt ist ein sehr kompakter Aufbau des Rotorsystems möglich.

Wenn das Rotorsystem axial in eine HF-Spulenanordnung eingeführt wird, ist ein Austausch des Rotorsystems in diese HF-Spulenanordnung im Allgemeinen sehr leicht möglich. Der Stator kann insbesondere gehandhabt (etwa eingeschoben oder herausgezogen) werden, ohne die HF-Spulenanordnung aus ihrer Probenkopfanordnung entfernen zu müssen. Eine Isolation, etwa eine Vakuumisolation, für die HF-Spulenanordnung ist sehr einfach einzurichten, insbesondere mit einer sich im Wesentlichen in axialer Richtung mit konstantem Innenradius erstreckenden Innenwand. Eine solche Isolation ist besonders gut mit dem erfindungsgemäßen Rotorsystem nutzbar. Insbesondere kann ein Teil des Stators (etwa das Hüllelement) als radial innenliegender Teil bzw. Innenwand einer Isolation einer HF-Spulenanordnung genutzt werden (vgl. oben).

Eine Verkleinerung des Radius R2 im Endabschnitt gegenüber dem Radius R1 im kreiszylinderförmigen Abschnitt entlang der axialen Richtung kann kontinuierlich oder abschnittsweise kontinuierlich oder auch mit einer oder mehreren Stufen erfolgen. Weiterhin kann der Übergang vom kreiszylindrischen Abschnitt zum Endabschnitt kontinuierlich oder auch mit einer Stufe erfolgen.

Man beachte, das die zweite Lagerfläche parallel zur Rotationsachse verlaufen kann, oder auch mit einem Konuswinkel zur Rotationsachse; das zweite Lager (und auch das erste Lager) hält den Rotor in radialer Richtung in Position.

Mit ADV=AD2 kann meist eine optimale Raumausnutzung für ein maximales Probenvolumen im Inneren der HF-Spulenanordnung erreicht werden.

### Weiterbildung mit Rotor mit gleichen Radiallager-Durchmessern

Bei einer alternativen Weiterbildung ist R2 = R1, wobei auch die zweite Lagerfläche am kreiszylindrischen Abschnitt des Rotors ausgebildet ist. Ein solches Rotor-Stator-System ist besonders einfach herzustellen, ermöglicht jedoch nicht so geringe Abstände zwischen HF-Spulenanordnung und Messsubstanz im Rotor.

### Weitere Weiterbildungen

Bevorzugt ist auch eine Weiterbildung, wobei in einer der Lagerbasen, insbesondere in der zweiten Lagerbasis, weiterhin ein drittes pneumatisches Lager ausgebildet ist, mit dem ein im Stator angeordneter Rotor axial gehalten werden kann, insbesondere wobei der Rotor eine senkrecht zur Rotationsachse ausgerichtete dritte Lagerfläche aufweist. Mit dem dritten pneumatischen Lager kann auf den Rotor eine axiale Haltekraft ausgeübt werden, um ein axiales Aufsetzen des Rotors im Stator zu verhindern.

Dabei kann vorgesehen sein, dass in der anderen der Lagerbasen, insbesondere in der ersten Lagerbasis, weiterhin ein Gegenlager ausgebildet ist, mit dem der im Stator angeordnete Rotor zusätzlich axial gehalten werden kann. Mittels des Gegenlagers kann das dritte pneumatische Lager unterstützt werden, etwa durch Ausübung von Druck am Gegenlager. Das Gegenlager kann insbesondere ausgebildet sein
- als pneumatisches Axiallager, insbesondere mit wenigstens einer Düsenaustrittsöffnung im Stator und mit einer vierten Lagerfläche an einem axialen Ende des Rotors, die orthogonal zur Rotationsachse verläuft,
- als pneumatisches Konuslager,
- als Lager auf Basis eines passiven Gegendruckaufbaus, insbesondere mit einem Stopfen oder einer Blende,
- als Lager auf Basis eines aktiven Gegendruckaufbaus, insbesondere mit einem beweglichen Stopfen, variabler Blende oder mit Luftanblasen ohne Lagerfläche.

### Erfindungsgemäße Verwendung

In den Rahmen der vorliegenden Erfindung fällt auch eine Verwendung einer erfindungsgemäßen, oben beschriebenen Probenkopfanordnung zur Vermessung einer Messsubstanz, die in einen Rotor eingefüllt ist, in einem MAS-NMR-Experiment, wobei der Rotor im Stator angeordnet ist, der Stator in das Stator-Lager eingeführt und fixiert ist, und der Rotor um die Rotationsachse rotiert, bevorzugt mit einer Frequenz von wenigstens 1 kHz und besonders bevorzugt mit einer Frequenz von wenigstens 10 kHz. Insbesondere kann zwischen MAS-NMR-Experimenten bei Bedarf (etwa zur Wartung oder für einen Austausch bei Beschädigung) ein Stator aus dem Stator-Lager axial herausgezogen werden, und ein Stator wieder in das Stator-Lager eingeschoben werden, ohne die HF-Spulenanordnung auszubauen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:

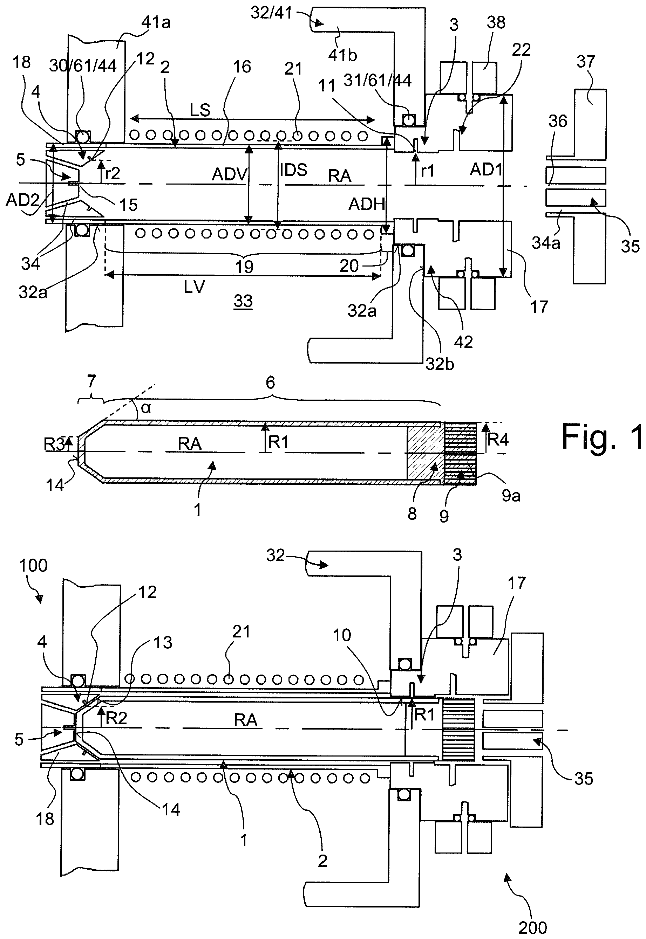

- Fig. 1: einen schematischen Querschnitt einer ersten Bauform eines MAS-NMR-Rotorsystems für die Erfindung, mit kegelstumpfförmigem vorderen Endabschnitt. Der Stator umfasst ein Hüllelement, ein Axiallager, zwei Radiallager und ein Gegenlager. Der Antrieb ist auf der dem Axiallager entgegengesetzten Seite ausgebildet. Die hier dargestellte Bauform beinhaltet eine Fixierung des Stators im Stator-Halter über O-Ringe, jedoch darüber hinaus keine weitere Axialsicherung. Darüberhinaus ist eine HF-Spulenanordnung bestehend aus einer Drahtspule dargestellt;

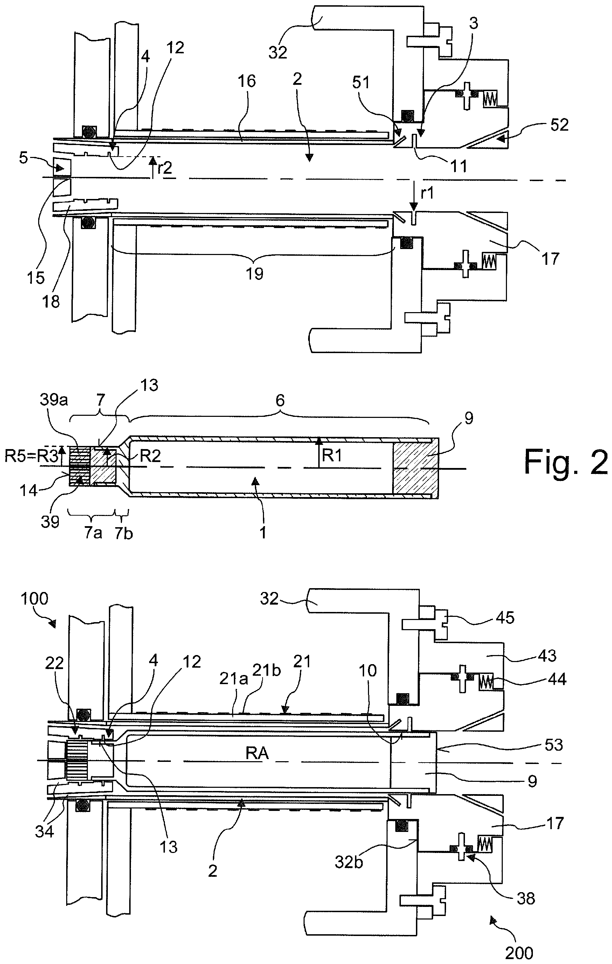

- Fig. 2: einen schematischen Querschnitt einer zweiten Bauform eines MAS-NMR-Rotorsystems für die Erfindung, mit größtenteils kreiszylinderförmigem vorderen Endabschnitt. Der Stator umfasst ein Hüllelement, ein Axiallager, zwei Radiallager und einen Antrieb, der im Bereich des vorderen Endabschnittes ausgebildet ist. Die hier dargestellte Bauform beinhaltet eine Axialsicherung des Stators im Stator-Halter mittels Federkraft. Darüberhinaus ist eine HF-Spulenanordnung umfassend einen Spulenträger mit aufgebrachter HF-Spule dargestellt;

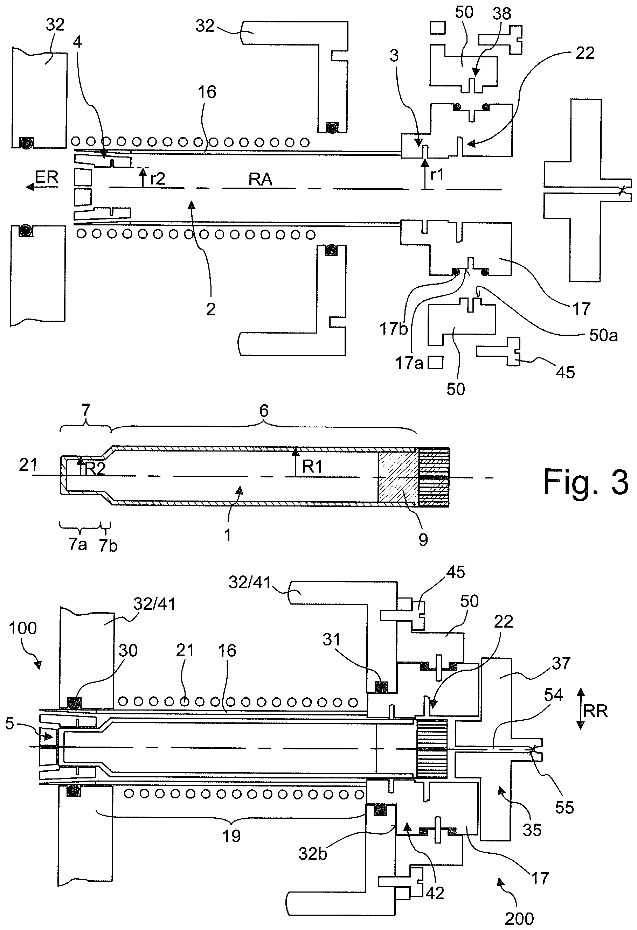

- Fig. 3: einen schematischen Querschnitt einer dritten Bauform eines MAS-NMR-Rotorsystems für die Erfindung, mit größtenteils kreiszylinderförmigem vorderen Endabschnitt. Der Stator umfasst ein Hüllelement, ein Axiallager, zwei Radiallager und einen Antrieb, der im hinteren Bereich des Rotors gegenüber dem Axiallager ausgebildet ist und eine Flussbegrenzung der Turbinenabluft zur Erhöhung der Haltekraft des Rotors im Stator aufweist. Die hier dargestellte Bauform beinhaltet eine Axialsicherung des Stators im Statorhalter mittels der Gasanschlüsse für Lager und Antrieb;

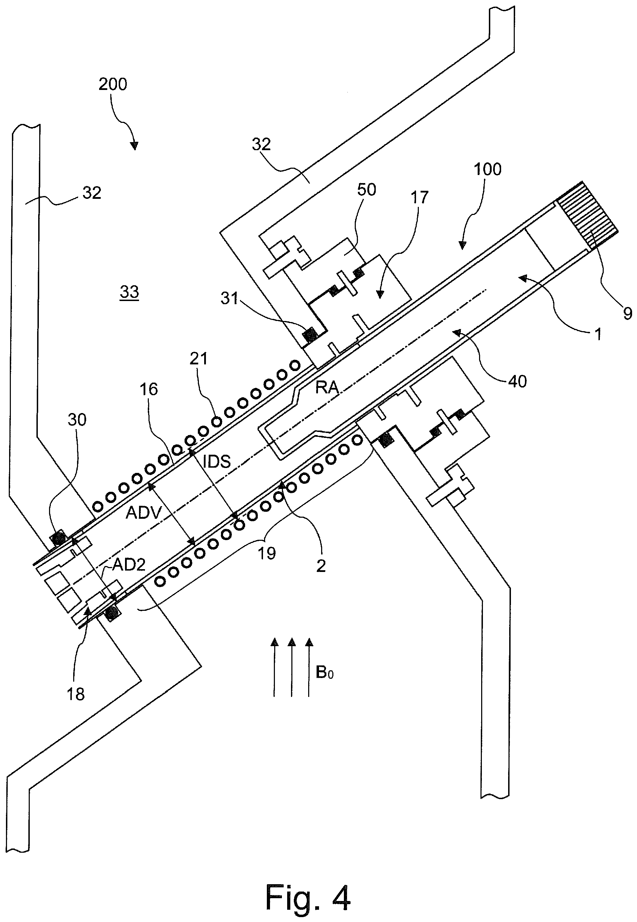

- Fig. 4: einen schematischen Querschnitt durch eine Ausführungsform einer erfindungsgemäßen Probenkopfanordnung, bei der der Stator in festem Winkel in Bezug auf die Probenkopfanordnung angebracht ist;

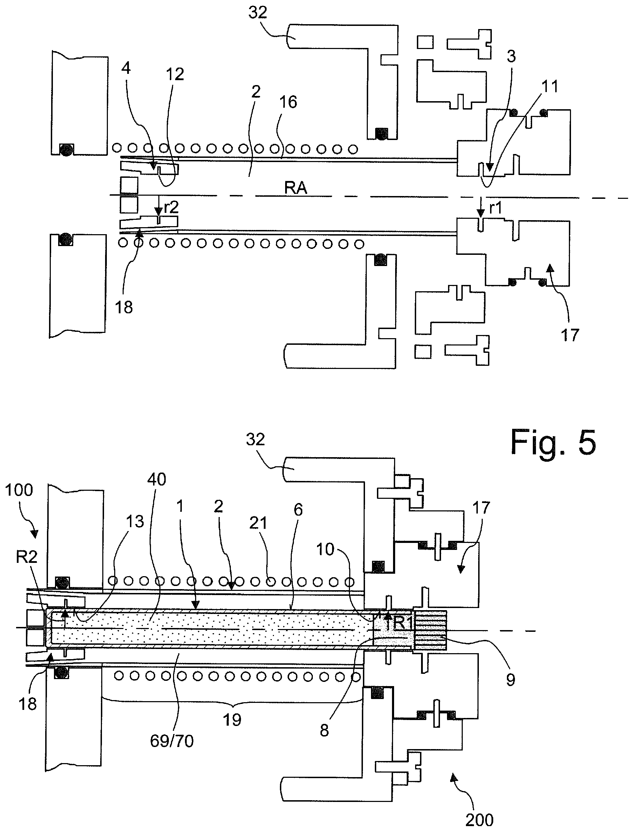

- Fig. 5: einen schematischen Querschnitt einer vierten Bauform eines MAS-NMR-Rotorsystems für die Erfindung, ähnlich wie in Fig. 3 dargestellt, jedoch mit vollständig kreiszylinderförmigem Rotor.

**Fig. 1** zeigt eine erste Bauform eines MAS-NMR-Rotorsystems 100 für die Erfindung, umfassend einen Rotor 1, in welchem eine Messsubstanz in fester oder semisolider Form (etwa ein Pulver oder Gel) angeordnet wird, und einen Stator 2. In Fig. 1 oben ist der Stator 2 (zusammen mit Teilen einer Stator-Halterung 32), in Fig. 1 Mitte der Rotor 1 und in Fig. 1 unten das gesamte MAS-NMR-Rotorsytem 100 mit Rotor 1 und Stator 2 (zusammen mit Teilen der Stator-Halterung 32) gezeigt. Das MAS-NMR-Rotorsystem 100 und die Stator-Halterung 32 sind Teil einer erfindungsgemäßen Probenkopfanordnung 200.

Der Stator 2 umfasst ein erstes pneumatisches Lager (hier Radiallager) 3, ein zweites pneumatisches Lager (hier Radiallager) 4 und ein drittes pneumatisches Lager (hier Axiallager) 5. Der Rotor 1 ist innerhalb des Stators 2 um eine Rotationsachse RA drehbar gelagert.

Der Rotor 1 umfasst einen kreiszylinderförmigen Abschnitt 6 und einen Endabschnitt 7, der das in Fig. 1 linksseitige (vordere), geschlossene Ende des Rotors 1 bildet. Der Endabschnitt 7 verläuft hier kegelstumpfförmig und verjüngt sich auf das linksseitige Ende zu; ein Konuswinkel α des Endabschnitts 7 gegenüber der Rotationsachse RA beträgt hier ca. 30°; bevorzugt sind allgemein 10° bis 45°. Am rechtsseitigen (hinteren) Ende des Rotors 1 ist eine Öffnung 8 ausgebildet, die mit einer Kappe 9 verschlossen ist, so dass in den Rotor 1 eingefüllte Messsubstanz während eines NMR-Experiments nicht verloren geht. An der Kappe 9 sind Gegenstrukturen 9a, etwa Prallflächen ausgebildet (nur schematisch angedeutet), durch die mit einem geeigneten Gasstrom eines pneumatischen Antriebs 22 die Rotation des Rotors 1 um die Rotationsachse RA bewirkt werden kann. Der Außenradius R4 der Kappe 9 entspricht ungefähr dem Radius R1 des Rotors 1 im kreiszylinderförmigen Abschnitt 6.

Der kreiszylinderförmige Abschnitt 6 weist den (äußeren) Radius R1 auf und bildet eine erste Lagerfläche 10 für das erste pneumatische Lager (Radiallager) 3 aus. Statorseitige Düsenaustrittsöffnungen 11 (am inneren Ende der Düsenaustrittsbohrung) des ersten pneumatischen Lagers (Radiallagers) 3 sind auf einem Radius r1 bezüglich der Rotationsachse RA angeordnet.

Das zweite pneumatische Lager (Radiallager) 4 verfügt über Düsenaustrittsöffnungen 12 bei einem Radus r2. Der Radius r2 ist deutlich kleiner als r1, hier mit ca. r2 = 0,65*r1. Der Radius R2 auf dem Endabschnitt 7 gegenüber den Düsenaustrittsöffnungen 12, wo eine zweite Lagerfläche 13 ausgebildet wird, beträgt deutlich weniger als R1, hier mit ca. R2 = 0,65*R1.

Das zweite pneumatische Lager (Radiallager) 4 leistet hier nicht nur die radiale Lagerung des Rotors 1 im Bereich des vorderen Endes, sondern kann bei entsprechender Auslegung der Strömungsverhältnisse auch zum axialen Halten des Rotors 1 beitragen.

Am linksseitigen (vorderen) axialen Ende des Rotors 1 bildet der Rotor 1 eine dritte Lagerfläche 14 aus, die zusammen mit einer Düsenaustrittsöffnung 15 das dritte pneumatische Lager (Axiallager) 5 ausbildet. Die dritte Lagerfläche 14 liegt senkrecht zur Rotationsachse RA und weist einen Außenradius R3 auf, der wiederum deutlich kleiner ist als R1, hier mit ca. R3 = 0,5*R1.

Die statorseitigen Teile des zweiten pneumatischen Lagers (Radiallagers) 4 und des dritten pneumatischen Lagers (Axiallagers) 5 umschließen becherförmig die dritte Lagerfläche 14 und hier auch den übrigen Endabschnitt 7. Zusätzlich zu den Düsenaustrittsöffnungen 12, 15 sind auch Abluftaustrittsöffnungen 34 im Stator 2 vorgesehen, um die Abluft vom Axiallager 5, vom zweiten Radiallager 4, je nach Ausführung aber auch, zumindest zu Teilen, vom ersten pneumatischen Lager (Radiallager) 3 und zusätzlich eventuell vorhandene Temperierluft nach außen zu leiten. Dies dient dazu, einen Gegendruck zu vermeiden oder zu minimieren, der der Haltekraft des Axiallagers 5 entgegenwirken würde. Der Endabschnitt 7 erstreckt sich hier über ca. 6,5% der gesamten Länge des Rotors 1 (einschließlich Kappe 9); allgemein bevorzugt sind 5% bis 25%.

In der in Fig. 1 dargestellten Ausführungsform sind die statorseitigen Teile des zweiten pneumatischen Lagers (Radiallagers) 4 und des dritten pneumatischen Lagers (Axiallagers) 5 so angeordnet, dass sie sich radial ungefähr genauso weit wie der Radius R1 des kreiszylinderförmigen Abschnitts 6 erstrecken. Insbesondere gilt hier r2 < R1. Hingegen nehmen die statorseitigen Teile des ersten pneumatischen Lagers (Radiallagers) 3 einen Raum jenseits von R1 ein.

Der Stator 2 bildet ein einheitliches Bauteil, wie in Fig. 1 ersichtlich. Dazu verfügt der Stator 2 über ein Hüllelement 16, welches eine erste Lagerbasis 17, in der der statorseitige Teil des ersten pneumatischen Lagers bzw. Radiallagers 3 ausgebildet ist, und eine zweite Lagerbasis 18, in der der statorseitige Teil des zweiten pneumatischen Lagers bzw. Radiallagers 4 (und hier auch der statorseitige Teil des dritten pneumatischen Lagers bzw. Axiallagers 5) ausgebildet ist, miteinander mechanisch verbindet. Das Hüllelement 16 verfügt über einen vorderen Abschnitt 19, der sich an die zweite Lagerbasis18 anschließt, und einen (größten) Außendurchmesser ADV aufweist, sowie hier über einen hinteren Abschnitt 20, mit einem (größten) Außendurchmesser ADH, der sich an das erste Lagerelement 17 anschließt. Der (größte) Außendurchmesser der ersten Lagerbasis 17 beträgt AD1, und der (größte) Außendurchmesser der zweiten Lagerbasis 18 beträgt AD2.

Der Stator 2 des MAS-NMR-Rotorsystems 100 durchragt mit der zweiten Lagerbasis 18 und dem vorderen Abschnitt 19 des Hüllelements 16 eine HF-Spulenanordnung 21, die einen kleinsten Innendurchmesser IDS aufweist. Der vordere Abschnitt 19 weist eine axiale Länge LV auf, die hier geringfügig größer ist als die axiale Länge LS der HF-Spulenanordnung 21. Die HF-Spulenanordnung ist hier als eine selbsttragende Drahtspule (ohne Spulenträger) ausgebildet.

Das MAS-NMR-Rotorsystem 100 wurde hier bis an den hinteren Abschnitt 20 axial (hier von der rechten Seite) in die HF-Spulenanordnung 21 hineingeschoben. Dafür ist eingerichtet, dass AD2 < IDS ist und auch ADV < IDS ist, wobei hier auch ADV = AD2 ist. Der Rotor 1 bzw. die enthaltene Messsubstanz kann radial sehr nahe an die HF-Spulenanordnung 21 heranrücken. Hingegen ist AD1 > IDS, so dass das erste pneumatische Lager (Radiallager) 3 mit einem großen Radius r1 der Düsenaustrittsöffnungen 11 ausgebildet sein kann, und auch AD1 > IDS eingerichtet werden kann, um die (hintere) radiale Lagerung des Rotors 1 zu verbessern. Für Wartungszwecke ist es ohne weiteres möglich, den Stator 2 aus der HF-Spulenanordnung 21 (hier nach rechts) axial herauszuziehen und nach einer Reparatur (oder einem Austausch, falls nötig) wieder in die HF-Spulenanordnung 21 hineinzuschieben (hier nach links), ohne die HF-Spulenanordnung 21 aus der MAS-NMR-Probenkopfanordnung 200 auszubauen.

Falls das dritte pneumatische Lager (Axiallager) 5, ggf. zusammen mit dem Halte-Beitrag des zweiten pneumatischen Lagers (Radiallagers) 4, nicht ausreicht, um den Rotor 1 im Rotationsbetrieb in axialer Richtung in Position zu halten, kann (wie in Fig. 1 dargestellt) ein Gegenlager 35 vorgesehen sein, das am hier kappenseitigen Ende beispielsweise mit einem Gasstrom durch eine Düsenaustrittsöffnung 36 den Rotor 1 auf das Axiallager 5 zu schiebt. Das Gegenlager 35 kann in einem klappbaren oder verschiebbaren Statorteil ausgebildet sein, das für einen Statorwechsel weggeklappt oder weggeschoben werden kann oder bei jedem Rotorwechsel montiert, z.B. aufgeschraubt werden kann (nicht näher dargestellt). In der gezeigten Ausführungsform ist das Gegenlager 35 in einen Verschlussdeckel 37 integriert, mit dem der Stator 2 bei eingeführtem Rotor 1 verschlossen wird; der Verschlussdeckel 37 weist hier auch Luftauslassöffnungen 34a auf.

Der Stator 2 ist in einer Stator-Halterung 32 gelagert, die für den Stator 2 ein Stator-Lager 41 ausbildet, in das der Stator 2 axial (parallel zur Rotationsachse RA) ein- und ausgeführt werden kann; gezeigt ist in Fig. 1 oben und unten der eingeführte Zustand. Das Stator-Lager 41 umfasst hier einen vorderen Teil 41a, der in der gezeigten Ausführungsform die zweite Lagerbasis 18 umgreift und eine radiale Begrenzung 32a für eine etwaige radiale Bewegung des Stators 2 ausbildet. Weiterhin umfasst das Stator-Lager 41 hier einen hinteren Teil 41b, der in den gezeigten Ausführungsformen die erste Lagerbasis 17 umgreift und ebenfalls eine radiale Begrenzung 32a ausbildet. Der hintere Teil 41b bildet auch einen axialen Anschlag 32b für den Stator 2 aus, an dem eine Schulter 42 der ersten Lagerbasis 17 anliegt. Zwischen den Teilen 41a, 41b des Stator-Lagers 41, radial unmittelbar zum Hüllelement 16 benachbart, ist die HF-Spulenanordnung 21 angeordnet, die in nicht näher dargestellter Weise in der MAS-NMR-Probenkopfanordnung 200 befestigt ist, etwa an der Stator-Halterung 32 (nicht jedoch am Stator 2).

In den Teilen 41a, 41b des Stator-Lagers 41 sind Nuten vorgesehen, in denen Dichtungen (Dichtungsringe) 30, 31 angeordnet sind, hier O-Ringe aus elastischem Material, etwa Gummi. Diese drücken hier umlaufend auf die Außenseiten der zweiten Lagerbasis 18 und der ersten Lagerbasis 17. Dadurch wird ein gasdichter, evakuierter Raum 33, der radial innen durch das Hüllelement 16 mitbegrenzt wird, abgedichtet. In diesem evakuierten Raum 33 kann die enthaltene HF-Spulenanordnung 21 bei guter thermischer Isolation temperiert werden, insbesondere auf eine kryogene Temperatur von beispielsweise 20 K.

Die Dichtungen 31, 30 fungieren in der Ausführungsform von Fig. 1 als stationäre (d.h. in der Stator-Halterung 32 unbewegliche) Sicherungsteile 61, die gleichzeitig die Funktion von elastischen Elementen 44 haben, die den eingeführten Stator 2 radial verspannen und dadurch im Kraftschluss den Stator 2 axial fixieren, soweit dies im Normalbetrieb in Hinblick auf die dabei zu erwarteten Kräfte erforderlich ist. Mit größerer Kraft kann der Stator 2 jedoch axial (hier nach rechts) herausgezogen werden, etwa für eine Wartung, ohne dass weitere Mechanismen gelöst werden müssten. Man beachte, dass beim Wiedereinführen des Stators 2 in die Stator-Halterung 32 an den Dichtungen 31, 30 eine gewisse Kraft (mechanischer Widerstand) überwunden werden muss.

Am Stator 2, hier an der ersten Lagerbasis 17, ist zudem eine Gasstromversorgung 38 angeschlossen.

Die **Fig. 2** zeigt eine zweite Bauform eines MAS-NMR-Rotorsystems 100 für die Erfindung, welches weitgehend der Bauform von Fig. 1 entspricht, so dass hier nur die wesentlichen Unterschiede dargestellt werden. Oben ist wiederum der Stator 2 (mit Teilen einer Stator-Halterung 32), in der Mitte der Rotor 1, und unten das MAS-NMR-Rotorsystem 100 mit Rotor 1 und Stator 2 gezeigt. Das MAS-NMR-Rotorsystem 100 und die Stator-Halterung 32 sind Teil einer erfindungsgemäßen Probenkopfanordnung 200.

In der gezeigten Ausführungsform weist der Rotor 1 einen Endabschnitt 7 auf, der in einem vorderen Teil 7a kreiszylinderförmig ausgebildet ist und in einem hinteren Teil 7b, der zum kreiszylinderförmigen Abschnitt 6 führt, konisch (kegelstumpfförmig) ausgebildet ist. Der Endabschnitt 7 bildet die zweite Lagerfläche 13 des zweiten pneumatischen Lagers (hier Radiallagers) 4 gegenüber den Düsenaustrittsöffnungen 12 im Bereich des kreiszylinderförmigen vorderen Teils 7a aus. Der Radius R2 der zweiten Lagerfläche 13 ist gleich dem Radius R3 der dritten Lagerfläche 14 des dritten pneumatischen Lagers (hier Axiallagers) 5, gegenüber der Düsenaustrittsöffnung 15. Sowohl R2 als auch R3 sind deutlich kleiner als der Radius R1 der ersten Lagerfläche 10 gegenüber den Düsenaustrittsöffnungen 11 des ersten pneumatischen Lagers (hier Radiallagers) 3. Ein Teil des Endabschnitts 7 wird hier durch einen Kappenaufsatz 39 des Rotors 1 ausgebildet. Am Kappenaufsatz 39 sind Gegenstrukturen 39a, etwa Prallflächen, für einen Antriebsgasstrom eines Antriebs 22 ausgebildet, mit dem der Rotor 1 in Rotation um die Rotationsachse RA versetzt werden kann.

Die Düsenaustrittsöffnungen 12 des zweiten pneumatischen Lagers (Radiallagers) 4 liegen bei einem Radius r2 deutlich kleiner als der Radius r1 der Düsenaustrittsöffnungen 11 des ersten pneumatischen Lagers (Radiallagers) 3, und auch deutlich kleiner als der (äußere) Radius R1 des zylinderförmigen Abschnitts 6, so dass auch hier eine sehr kompakte Bauform erreichbar ist, die sich leicht in eine HF-Spulenanordnung 21 axial von der Seite einschieben lässt. Die HF-Spulenanordnung 21 ist hier mit einem rohrförmigen Spulenträger 21a ausgebildet, auf dem die Leiterelemente 21b der HF-Spulenanordnung 21 außenseitig angeordnet sind.

In der gezeigten Ausführungsform weist der Stator 2 Temperiergasdüsen 51 auf, mit denen im Stator 2 um den Rotor 1 herum, und dadurch auch im Rotor 1, eine gewünschte Temperatur einstellbar ist. Beispielsweise kann eine moderate Kühlung von Messsubstanz im Rotor 1 vorgenommen werden, um ein Denaturieren von Proteinen während einer NMR-Messung zu verhindern, beispielsweise bei ca. 0°C. Weiterhin sind hier Druckgasdüsen 52 vorgesehen, mit denen der Druck an einer Prallfläche 53 des Rotors 1, hier an der Kappe 9 ausgebildet, eingestellt werden kann, um die axiale Position des Rotors 1 während der Rotation um die Rotationsachse RA zu sichern.

Bei dieser Ausführungsform kann ein gleich großer oder größerer Gasstrom am zweiten pneumatischen Lager (Radiallager) 4 eingesetzt als am ersten pneumatischen Lager (Radiallager) 3, um eine näherungsweise gleiche Radiallagersteifigkeit zu erreichen. Insbesondere kann das zweite Radiallager 4 mit einem höheren Druck beaufschlagt werden als das erste Radiallager. Falls erforderlich, kann auch bei dieser Ausführungsform ein Gegenlager vorgesehen sein (nicht dargestellt, vgl. aber Fig. 1 und Fig. 3).

In der Ausführungsform von Fig. 2 ist ein abnehmbares Sicherungsteil 43 vorgesehen, welches den Stator 2 an der ersten Lagerbasis 17 hintergreift. Das abnehmbare Sicherungsteil 43 ist in einer sichernden, an der Stator-Halterung 32 verschraubten Stellung gezeigt, vgl. die Schrauben 45. Das Sicherungsteil 43 drückt mit elastischen Elementen 44, hier Federn oder alternativ Elastomerelementen, von hinten gegen den Stator 2, wodurch dieser am axialen Anschlag 32b anliegend fixiert wird. Der Stator 2 ist also elastisch gegen den axialen Anschlag 32b verspannt. Um den Stator 2 aus der Stator-Halterung 32 axial herauszuziehen (hier nach rechts), können die Schrauben 45 gelöst und das Sicherungsteil 43 (einschließlich Federn) entfernt werden.

Man beachte, dass das abnehmbare Sicherungsteil 43 hier auch eine Gasstromversorgung 38 beinhaltet.

Das Hüllrohr 16 weist hier keinen hinteren Abschnitt auf, der gegenüber einem vorderen Abschnitt 19 radial weiter wäre, insofern erstreckt sich hier der vordere (in die HF-Spulenanordnung einführbare) Abschnitt 19 über die gesamte Länge des Hüllrohrs 16.

Die **Fig. 3** zeigt eine dritte Bauform eines MAS-NMR-Rotorsystems 100 für die Erfindung, welches weitgehend der Ausführungsform von Fig. 1 entspricht, so dass hier nur die wesentlichen Unterschiede dargestellt werden. Oben ist wiederum der Stator 2 gezeigt, jedoch in einem nur teilweise in Einführrichtung ER in die Stator-Halterung 32 eingeschoben Zustand, bei noch nicht montiertem Sicherungsteil 50. In der Mitte ist der Rotor 1 gezeigt, und unten das gesamte MAS-NMR-Rotorsystem 100 mit Rotor 1 und Stator 2. Das MAS-NMR-Rotorsystem 100 und die Stator-Halterung 32 sind Teil einer erfindungsgemäßen Probenkopfanordnung 200.

Bei dieser Bauform weist der Rotor 1 wiederum einen Endabschnitt 7 mit einem kreiszylinderförmigen vorderen Teil 7a und einem konischen hinteren Teil 7b auf (vgl. Fig. 2), jedoch ohne Verwendung eines Kappenaufsatzes am vorderen Ende. Der pneumatische Antrieb 22 greift an einer Kappe 9 am hinteren Ende des Rotors 1 an. Das Hüllrohr 16 weist hier keinen hinteren Abschnitt auf, der gegenüber einem vorderen Abschnitt 19 radial weiter wäre, insofern erstreckt sich hier der vordere (in die HF-Spulenanordnung 21 einführbare) Abschnitt 19 über die gesamte Länge des Hüllrohrs 16.

Das (hier mehrere separate Komponenten umfassende) Sicherungsteil 50 dient dazu, den Stator 2 im Statorlager 41 in einem axial (bezüglich Einführrichtung ER bzw. entlang der Rotationsachse RA) ganz eingefahrenen Zustand (vgl. Fig. 3 unten, mit Schulter 42 und axialem Anschlag 32b aneinander anliegend) zu sichern, so dass der Stator 2 sich während einer Messung axial nicht bewegen kann.

Das Sicherungsteil 50 weist Nasen 50a auf, die in Nuten 17a an der ersten Lagerbasis 17 einführbar sind. Im eingeführten Zustand der Nasen 50a kann das Sicherungsteil 50 mittels Schrauben 45 an der Stator-Halterung 32 angeschraubt werden, vgl. Fig. 3 unten für den eingeschraubten Zustand. Über in radialer Richtung RR eingepresste Dichtungen 17b, oder auch direkt über die Nasen 50a und einen jeweiligen Nutgrund der Nuten 17a, wird der Stator 2 in radialer Richtung RR eingeklemmt. Durch Kraftschluss wird dadurch auch eine weitere Sicherung des Stators 2 in axialer Richtung im Statorlager 41 erreicht, über die Wirkung der Dichtungen bzw. Dichtungsringe 30, 31 hinaus. Zudem hintergreifen die Nasen 50a auch die erste Lagerbasis 17 in den Nuten 17a bezüglich der axialen Richtung, wodurch eine zusätzliche Sicherung eintritt.

Das Sicherungsteil 50 beinhaltet hier auch die Gasstromversorgung 38, wobei die Dichtungen 17b den Versorgungsgasstrom abdichten.

Im Verschlussdeckel 37 ist hier ein Gegenlager 35 eingerichtet, indem der Abfluss der Antriebsluft des Antriebs 22 begrenzt wird, so dass ein Gegendruck aufgebaut wird, der den Rotor 1 auf das dritte pneumatische Lager (hier Axiallager) 5 zu schiebt. In einem Gasauslasskanal 54 ist dafür eine verstellbare Gasstrom-Begrenzungseinrichtung, hier eine variable Blende 55, vorgesehen.

**Fig. 4** zeigt in einer schematischen Schnittansicht eine Ausführungsform einer erfindungsgemäßen Probenkopfanordnung 200, in der ein MAS-NMR-Rotorsystem 100 verbaut wurde, wie in Fig. 3 dargestellt.

Die Probenkopfanordnung 200 umfasst einen Stator 2, in welchem ein Rotor 1 drehbar um eine Rotationsachse RA gelagert ist; der Rotor 1 wird in Fig. 4 gerade gewechselt und ist deshalb nur teilweise in den Stator 2 axial eingeschoben. Der Rotor 1 ist hinterenends mit einer Kappe 9 verschlossen. Der Stator 2 weist zwei Lagerbasen 17, 18, die über das Hüllelement 16 mechanisch verbunden sind.

Die Probenkopfanordnung 200 weist eine HF-Spulenanordnung 21 auf, wobei der kleinste Innendurchmesser IDS der HF-Spulenanordnung 21 größer als der (größte) Außendurchmesser AD2 der zweiten Lagerbasis 18 und der (größte) Außendurchmesser ADV in einem vorderen Abschnitt 19 des Hüllelements 16 (der hier die ganze Länge des Hüllelements 16 umfasst). Dadurch kann der Stator 2 bei der Montage oder zu Wartungszwecken bei entferntem Sicherungsbauteil 50 durch die HF-Spulenanordnung 21 hindurch geführt werden. Im eingeführten (eingeschobenen) Zustand wird der Stator 2 in einer Stator-Halterung 32 gehalten, die dafür ein Stator-Lager ausbildet. Die Lagerung ist so ausgebildet, dass die Rotationsachse RA unter dem magischen Winkel von 54,7° gegenüber einem hier vertikal verlaufenden Magnetfeld B₀ ausgerichtet ist.

Der nach radial außen gasdichte Stator 2 mit gasdichtem Hüllelement 16 ist hier im Bereich der Lagerbasen 17, 18 mit den Dichtungen 30, 31 gegenüber der Stator-Halterung 32 abgedichtet, so dass das der Stator 2 bzw. das Hüllelement 16 einen Raum 33 mitbegrenzt; der Raum 33 wird hier auch durch die Stator-Halterung 32 und weitere, nicht näher dargestellte Wände begrenzt. In dem Raum 33, der auch die HF-Spulenanordnung 21 enthält, ist hier ein Vakuum eingerichtet, um die HF-Spulenanordnung 21 thermisch zu isolieren.

Dadurch ist es möglich, während einer MAS-NMR-Messung die HF-Spulenanordnung 21 auf eine kryogene Temperatur (beispielsweise 77 K, entsprechend flüssigem Stickstoff bei Normaldruck oder bei Kühlung z.B. mit flüssigem oder gasförmigem Helium auch tiefere Temperaturen, insbesondere ≤ 40 K, ≤ 20 K oder sogar im Bereich um 4,2 K, entsprechend flüssigem Helium bei Normaldruck) zu kühlen, während die Messsubstanz 40 im Rotor 1 auf einer Temperatur in der Nähe der Raumtemperatur bleibt bzw. auf eine Temperatur im Bereich von -250 °C bis + 1000 °C, insbesondere von -50°C bis + 150°C und besonders bevorzugt in einem Temperaturbereich von 0°C bis + 50°C temperiert werden kann.

Während der Messung rotiert der Rotor 1 im Stator 2 um die Rotationsachse RA, typischerweise mit einer Frequenz von 10 kHz oder mehr, insbesondere mit Drehzahlen im Bereich 1 kHz bis vs/(2π R1), wobei vs die Schallgeschwindigkeit des den Rotor 1 umgebenden Gases bei vorliegenden Druck/Temperaturbedingungen ist, und die HF-Spulenanordnung 21 strahlt HF-Pulse in die Messsubstanz 40 im Rotor 1 ein und/oder empfängt HF-Signale aus der Messsubstanz 40. Das starke statische Magnetfeld B₀ wirkt dabei (mit vertikaler Ausrichtung in Fig. 4) auf die Messsubstanz 40 ein.

Bevorzugt werden alle Gasströme an den beiden Enden des axial herausnehmbaren Stators 2 herausgeleitet, so dass es leicht gesammelt und rückgeführt werden kann. Dies ist insbesondere für Tieftemperatur-MAS vorteilhaft, um bei Betrieb mit He-Gas dieses nicht in die Raumluft zu verlieren. Bevorzugt wird das Gas unmittelbar in einen Dewar überführt, sodass es sich nicht unnötig aufwärmt und ein gekapselter Gaskreislauf möglich wird, der lediglich die Leitungsverluste und die Reibung im Rotorsystem 100 ausgleichen (nachkühlen) muss. Das Nachkühlen erfolgt bevorzugt mit Wärmetauschern und Kompression des Gases bei Raumtemperatur (nicht näher dargestellt).

Ebenso ist es von Vorteil, die Gasströme an beiden Enden des Stators 2 zu sammeln, für den Fall der Verwendung der MAS-NMR-Probenkopfanordnung 200 mit toxischen, kanzerogenen, explosiven, radioaktiven oder biogefährlichen Messproben.

Die **Fig. 5** zeigt eine vierte Bauform eines MAS-NMR-Rotorsystems 100 für die Erfindung, welches weitgehend der Ausführungsform von Fig. 3 entspricht, so dass hier nur die wesentlichen Unterschiede dargestellt werden. In Fig. 5 oben ist der Stator 2 mit Teilen einer Stator-Halterung 32 gezeigt, in die er teilweise axial hineingeschoben ist, und in Fig. 1 unten ist das MAS-NMR-Rotorsystem 100 mit Stator 2 und Rotor 1 sowie Teilen der Stator-Halterung 32 im vollständig axial eingeschobenen Zustand gezeigt. Das MAS-NMR-Rotorsystem 100 ist Teil einer erfindungsgemäßen MAS-NMR-Probenkopfanordnung 200.

Bei der gezeigten Bauform ist der Rotor 1 insgesamt kreiszylinderförmig mit einem einheitlichen Radius ausgebildet, so dass der Radius R1 der ersten Lagerfläche 10 des ersten pneumatischen Lagers (Radiallagers) 3 und der Radius R2 der zweiten Lagerfläche 13 des zweiten pneumatischen Lagers (Radiallagers) 4 hier gleich sind, also mit R1=R2. Am hinteren Ende des Rotors 1 verschließt eine Kappe 9 eine Öffnung 8 des beispielsweise aus Glas bestehenden, geschlossen röhrchenartigen (in Fig. 5 linksseitigen) Teils des Rotors 1, wobei die Kappe 9 einen Radius R4 aufweist, der gleich ist dem Radius R1 im Bereich des kreiszylinderförmigen Abschnitts 6. Der Rotor 1 mit einheitlichem Radius ist einfach herzustellen, wenig bruchempfindlich, bei Befüllung und Transport gut zu handhaben und auch bei der MAS-NMR-Messung bezüglich seiner Rotation um die Rotationsachse RA gut zu kontrollieren.

Der Stator 2 verfügt hier über eine erste Lagerbasis 17, eine zweite Lagerbasis 18 und ein die Lagerbasen 17, 18 verbindendes Hüllelement 16. Der Radius r1 an den Düsenöffnungen 11 des ersten pneumatischen Lagers (Radiallagers) 3 ist hier gleich dem Radius r2 an den Düsenaustrittsöffnungen 12 des zweiten pneumatischen Lagers (Radiallagers) 4.

Da sich der Radius des Rotors 1 jenseits der zweiten Lagerbasis 18 nicht erweitert, verbleibt hier ein relativ großer Raum 69 um den Rotor 1 bzw. ein relativ großer radialer Spalt 70 zwischen der Außenseite des Rotors 1 und der Innenseite des Stators 2 bzw. des Hüllrohrs 16 im vorderen Abschnitt 19. Dadurch kann eine besonders effiziente Temperierung des Rotors 1 erfolgen, jedoch wird das Signal zu Rausch Verhältnis durch die vergleichsweise geringe Menge an Messsubstanz 40 radial innerhalb der HF-Spulenanordnung 21 reduziert.

### Bezugszeichenliste

- 1: Rotor
- 2: Stator
- 3: erstes pneumatisches Lager (Radiallager)
- 4: zweites pneumatisches Lager (Radiallager)
- 5: drittes pneumatisches Lager (Axiallager)
- 6: kreiszylinderförmiger Abschnitt
- 7: Endabschnitt
- 7a: vorderer Teil (Endabschnitt)
- 7b: hinterer Teil (Endabschnitt)
- 8: Öffnung
- 9: Kappe
- 9a: Gegenstrukturen
- 10: erste Lagerfläche
- 11: Düsenaustrittsöffnungen (erstes Radiallager)
- 12: Düsenaustrittsöffnungen (zweites Radiallager)
- 13: zweite Lagerfläche
- 14: dritte Lagerfläche
- 15: Düsenaustrittsöffnungen (Axiallager)
- 16: Hüllelement
- 17: erste Lagerbasis
- 17a: Nuten
- 17b: Dichtungen
- 18: zweite Lagerbasis
- 19: vorderer Abschnitt
- 20: hinterer Abschnitt
- 21: HF-Spulenanordnung
- 21a: Spulenträger
- 21b: Leiterelemente
- 22: pneumatischer Antrieb
- 30: zweite Dichtung (Dichtungsring)
- 31: erste Dichtung (Dichtungsring)
- 32: Stator-Halterung
- 32a: radiale Begrenzung
- 32b: axialer Anschlag
- 33: gasdichter (evakuierter) Raum
- 34: Luftauslassöffnungen
- 34a: Luftauslassöffnungen (Gegenlager)
- 35: Gegenlager
- 36: Düsenaustrittsöffnungen (Gegenlager)
- 37: Verschlussdeckel
- 38: Gasstromversorgung
- 39: Kappenaufsatz
- 39a: Gegenstrukturen
- 40: Messsubstanz
- 41: Stator-Lager
- 41a: vorderer Teil (Stator-Lager)
- 41b: hinterer Teil (Stator-Lager)
- 42: Schulter
- 43: abnehmbares, axial hintergreifendes Sicherungsteil
- 44: elastisches Element
- 45: Schraube
- 50: bewegliches Sicherungsteil
- 50a: Nasen
- 52: Druckgasdüsen
- 53: Prallfläche
- 54: Gasauslasskanal
- 55: variable Blende
- 61: stationäres Sicherungsteil
- 69: Raum um Rotor
- 70: radialer Spalt
- 100: MAS-NMR-Rotorsystem
- 200: Probenkopfanordnung
- AD1: Außendurchmesser (erste Lagerbasis)
- AD2: Außendurchmesser (zweite Lagerbasis)
- ADV: Außendurchmesser vorderer Abschnitt
- ADH: Außendurchmesser hinterer Abschnitt
- ER: Einführrichtung
- IDS: kleinster Innendurchmesser (HF-Spulenanordnung)
- R1: Radius (erste Lagerfläche)
- R2: Radius (zweite Lagerfläche)
- R3: Außenradius (dritte Lagerfläche)
- R4: Radius (Kappe)
- R5: Radius (Kappenaufsatz)
- r1: Radius (Düsenaustrittsöffnungen erstes Radiallager)
- r2: Radius (Düsenaustrittsöffnungen zweites Radiallager)
- RA: Rotationsachse
- RR: radiale Richtung

## Patentansprüche

1. MAS-NMR-Probenkopfanordnung (200), umfassend einen an einer Rotationsachse (RA) ausgerichteten Stator (2) zur Lagerung eines Rotors (1) mit einer Messsubstanz (40), eine Stator-Halterung (32), und eine HF-Spulenanordnung (21) zum Einstrahlen von HF-Pulsen in die Messsubstanz (40) im Rotor (1) und/oder zum Empfangen von HF-Signalen aus der Messsubstanz (40) im Rotor (1), wobei der Stator (2) im eingeführten Zustand die HF-Spulenanordnung (21) durchragt,
**dadurch gekennzeichnet,**
**dass** die Stator-Halterung (32) mit einem Stator-Lager (41) ausgebildet ist, in das der Stator (2) axial ein- und ausführbar ist,
wobei der Stator (2) zum Ein- und Ausführen durch die HF-Spulenanordnung (21) hindurchführbar ist,
und wobei die Probenkopfanordnung (200) Mittel umfasst, mit denen der Stator (2) im eingeführten Zustand im Stator-Lager (41) temporär axial fixierbar ist,
und **dass** die Stator-Halterung (32) einen axialen Anschlag (32b) ausbildet, der eine maximal axial eingefahrene Position des Stators (2) in der Stator-Halterung (32) definiert.

2. Probenkopfanordnung (200) nach Anspruch 1, **dadurch gekennzeichnet, dass** der Stator (2) eine erste Lagerbasis (17), ein Hüllelement (16) und eine zweite Lagerbasis (18) umfasst, wobei das Hüllelement (16) die erste Lagerbasis (17) und die zweite Lagerbasis (18) axial miteinander verbindet, und wobei die erste Lagerbasis (17) ein erstes pneumatisches Lager (3) ausbildet, und die zweite Lagerbasis (18) ein zweites pneumatisches Lager (4) ausbildet,
dass die zweite Lagerbasis (18) einen größten Außendurchmesser AD2 aufweist,
dass das Hüllelement (16) einen vorderen Abschnitt (19) aufweist, der sich an die zweite Lagerbasis (18) axial anschließt und einen größten Außendurchmesser ADV aufweist,
dass die HF-Spulenanordnung (21) einen kleinsten Innendurchmesser IDS aufweist,
und dass AD2 < IDS und weiterhin ADV < IDS.

3. Probenkopfanordnung (200) nach Anspruch 2, **dadurch gekennzeichnet, dass** die erste Lagerbasis (17) und/oder das Hüllelement (16) im Bereich der ersten Lagerbasis (17) einen größten Außendurchmesser AD1 aufweist, und dass AD1 > IDS.

4. Probenkopfanordnung (200) nach Anspruch 2 oder 3, **dadurch gekennzeichnet, dass** die Stator-Halterung (32) eine erste Dichtung (31) aufweist, mit der der die erste Lagerbasis (17) und/oder das Hüllelement (16) im Bereich der ersten Lagerbasis (17) gegenüber der Stator-Halterung (32) gasdicht abgedichtet wird.

5. Probenkopfanordnung (200) einem der Ansprüche 2 bis 4, **dadurch gekennzeichnet, dass** die Stator-Halterung (32) eine zweite Dichtung (30) aufweist, mit der die zweite Lagerbasis (18) und/oder das Hüllelement (16) im Bereich der zweiten Lagerbasis (18) gegenüber der Stator-Halterung (32) gasdicht abgedichtet wird.

6. Probenkopfanordnung (200) nach einem der Ansprüche 2 bis 5, **dadurch gekennzeichnet, dass** das Hüllelement (16) gasdicht ausgebildet ist.

7. Probenkopfanordnung (200) nach einem der Ansprüche 2 bis 6, **dadurch gekennzeichnet, dass** die Probenkopfanordnung (200) im eingeführten Zustand des Stators (2) einen gasdichten Raum (33) ausbildet, der durch das Hüllelement (16) mit begrenzt wird, und in welchem die HF-Spulenanordnung (21) angeordnet ist.

8. Probenkopfanordnung (200) nach Anspruch 7, **dadurch gekennzeichnet dass** der gasdichte Raum (33) evakuiert ist.

9. Probenkopfanordnung (200) nach Anspruch 7 oder 8, **dadurch gekennzeichnet, dass** die HF-Spulenanordnung (21) im gasdichten Raum (33) auf eine kryogene Temperatur T gekühlt ist, bevorzugt mit T ≤ 100 K, besonders bevorzugt mit T ≤ 40 K oder T ≤ 20 K.

10. Probenkopfanordnung (200) nach Anspruch 7 oder 8, **dadurch gekennzeichnet, dass** ein den Rotor (1) umgebender Raum (69), insbesondere innerhalb des Stators (2), auf eine kryogene Temperatur T_{R} gekühlt ist, bevorzugt mit T_{R} ≤ 100 K, besonders bevorzugt mit T_{R} ≤ 40 K oder T_{R} ≤ 20 K.

11. Probenkopfanordnung (200) nach einem der vorhergehenden Ansprüche, **dadurch gekennzeichnet, dass** die Mittel, mit denen der Stator (2) im eingeführten Zustand im Stator-Lager (41) axial fixierbar ist, ein bewegliches oder abnehmbares Sicherungsteil (43; 50) umfassen, das in einer sichernden Stellung den Stator (2) axial hintergreift, insbesondere wobei das bewegliche oder abnehmbare Sicherungsteil (43; 50) am Stator (2) im Bereich der ersten Lagerbasis (17) angreift.

12. Probenkopfanordnung (200) nach einem der vorhergehenden Ansprüche, **dadurch gekennzeichnet, dass** die Mittel, mit denen der Stator (2) im eingeführten Zustand im Stator-Lager (41) axial fixierbar ist, wenigstens ein stationäres Sicherungsteil (61) umfassen, wobei das stationäre Sicherungsteil (61) mit einem elastischen Element (44) ausgebildet ist, das im eingeführten Zustand des Stators (2) in radialer Richtung (RR) auf den Stator (2) drückt,
insbesondere wobei zwei stationäre Sicherungsteile (61) vorgesehen sind, die als Dichtungsringe (31, 30) ausgebildet sind.

13. Probenkopfanordnung (200) nach einem der vorhergehenden Ansprüche, **dadurch gekennzeichnet, dass** der axiale Anschlag (32b) mit einer Schulter (42) des Stators (2) zusammenwirkt, die durch die erste Lagerbasis (17) oder das Hüllelement (16) in einem Bereich, der die erste Lagerbasis (17) umgreift, ausgebildet ist.

14. Probenkopfanordnung (200) nach Anspruch 2 oder einem der Ansprüche 3 bis 13, sofern rückbezogen auf Anspruch 2, **dadurch gekennzeichnet, dass** das erste pneumatische Lager (3) und das zweite pneumatische Lager (4) dazu ausgebildet sind, einen Rotor (1) im Stator (2) radial zu lagern,
und dass in den Stator (2) ein Rotor (1) eingeführt ist, welcher im Bereich des ersten pneumatischen Lagers (3) an einem kreiszylinderförmigen Abschnitt (6) des Rotors (1) eine erste Lagerfläche (10) bei einem Radius R1 ausbildet, und welcher im Bereich des zweiten pneumatischen Lagers (4) eine zweite Lagerfläche (13) bei einem Radius R2 ausbildet.

15. Probenkopfanordnung (200) nach Anspruch 2 oder einem der Ansprüche 2 bis 14, sofern rückbezogen auf Anspruch 2, **dadurch gekennzeichnet, dass** in einer der Lagerbasen (17, 18), insbesondere in der zweiten Lagerbasis (18), weiterhin ein drittes pneumatisches Lager (5) ausgebildet ist, mit dem ein im Stator (2) angeordneter Rotor (1) axial gehalten werden kann, insbesondere wobei der Rotor (1) eine senkrecht zur Rotationsachse (RA) ausgerichtete dritte Lagerfläche (14) aufweist.

16. Probenkopfanordnung (200) nach Anspruch 15, **dadurch gekennzeichnet, dass** in der anderen der Lagerbasen (17, 18), insbesondere in der ersten Lagerbasis (17), weiterhin ein Gegenlager (35) ausgebildet ist, mit dem der im Stator (2) angeordnete Rotor (1) zusätzlich axial gehalten werden kann.

17. Verwendung einer Probenkopfanordnung (200) nach einem der vorhergehenden Ansprüche zur Vermessung einer Messsubstanz (40), die in einen Rotor (1) eingefüllt ist, in einem MAS-NMR-Experiment, wobei der Rotor (1) im Stator (2) angeordnet ist, der Stator (2) in das Stator-Lager (41) eingeführt und fixiert ist, und der Rotor (1) um die Rotationsachse (RA) rotiert, bevorzugt mit einer Frequenz von wenigstens 1 kHz und besonders bevorzugt mit einer Frequenz von wenigstens 10 kHz.

## Claims

1. An MAS NMR probe head arrangement (200), comprising a stator (2) aligned along an axis of rotation (RA) to support a rotor (1) having a measurement substance (40), a stator mount (32), and an RF coil arrangement (21) to emit RF pulses into the measurement substance (40) in the rotor (1) and/or to receive RF signals from the measurement substance (40) in the rotor (1), wherein the stator (2), when inserted, passes through the RF coil arrangement (21),
**characterized in that**
the stator mount (32) is formed with a stator bearing (41) into which the stator (2) can be axially inserted and extracted,
wherein the stator (2) can be fed through the RF coil arrangement (21) for its insertion and extraction,
and wherein the probe head arrangement (200) comprises means with which the stator (2) can be temporarily fixed axially in the stator bearing (41) when inserted,
and that the stator mount (32) forms an axial stop (32b) which defines a maximum axially inserted position of the stator (2) in the stator mount (32).

2. The probe head arrangement (200) according to claim 1, **characterized in that** the stator (2) comprises a first bearing base (17), a sleeve element (16), and a second bearing base (18), wherein the sleeve element (16) connects the first bearing base (17) and the second bearing base (18) to each other axially, and wherein the first bearing base (17) forms a first pneumatic bearing (3) and the second bearing base (18) forms a second pneumatic bearing (4),
the second bearing base (18) has a greatest external diameter AD2,
the sleeve element (16) has a frontal section (19) which adjoins the second bearing base (18) axially and has a greatest external diameter ADV,
the RF coil arrangement (21) has a least inner diameter IDS, and AD2 < IDS and ADV < IDS.

3. The probe head arrangement (200) according to claim 2, **characterized in that** the first bearing base (17) and/or the sleeve element (16) has/have a greatest external diameter AD1 in the region of the first bearing base (17), and **in that** AD1> IDS.

4. The probe head arrangement (200) according to claim 2 or 3, **characterized in that** the stator mount (32) has a first seal (31) with which the first bearing base (17) and/or the sleeve element (16) is/are sealed in a gas-tight manner against the stator mount (32) in the region of the first bearing base (17).

5. The probe head arrangement (200) according to any one of the claims 2 to 4, **characterized in that** the stator mount (32) has a second seal (30) with which the second bearing base (18) and/or the sleeve element (16) is/are sealed in a gas-tight manner against the stator mount (32) in the region of the second bearing base (18).

6. The probe head arrangement (200) according to any one of the claims 2 to 5, **characterized in that** the sleeve element (16) is gas-tight.

7. The probe head arrangement (200) according to any one of the claims 2 to 6, **characterized in that** the probe head arrangement (200), when the stator (2) is inserted, forms a gas-tight space (33) which is also bounded by the sleeve element (16), and in which the RF coil arrangement (21) is arranged.

8. The probe head arrangement (200) according to claim 7, **characterized in that** the gas-tight space (33) is evacuated.

9. The probe head arrangement (200) according to claim 7 or 8, **characterized in that** the RF coil arrangement (21) in the gas-tight space (33) is cooled to a cryogenic temperature T, preferably where T ≤ 100 K, and more preferably where T ≤ 40 K or T ≤ 20 K.

10. The probe head arrangement (200) according to claim 7 or 8, **characterized in that** a space (69) surrounding the rotor (1), in particular within the stator (2), is cooled to a cryogenic temperature T_{R}, preferably where T_{R} ≤ 100 K, especially preferably where T_{R} ≤ 40 K or T_{R} ≤ 20 K.

11. The probe head arrangement (200) according to any one of the preceding claims, **characterized in that** the means by which the stator (2) can be axially fixed in the stator bearing (41) when inserted comprise a movable or detachable retaining part (43; 50) which axially engages behind the stator (2) in a retaining position,
in particular, wherein the movable or detachable retaining part (43; 50) engages on the stator (2) in the region of the first bearing base (17).

12. The probe head arrangement (200) according to any one of the preceding claims, **characterized in that** the means by which the stator (2) can be axially fixed in the stator bearing (41) when inserted comprise at least one stationary retaining part (61), wherein the stationary retaining part (61) is designed with an elastic element (44) which, when the stator (2) is inserted, presses against the stator (2) in the radial direction (RR), particularly wherein there are two stationary retaining parts (61) which are designed as sealing rings (31, 30).

13. The probe head arrangement (200) according to any one of the preceding claims, **characterized in that** the axial stop (32b) cooperates with a shoulder (42) of the stator (2) formed by the first bearing base (17) or the sleeve element (16) in a region surrounding the first bearing base (17).

14. The probe head arrangement (200) according to claim 2 to or any one of the claims 3 to 13 when dependent on claim 2, **characterized in that** the first pneumatic bearing (3) and the second pneumatic bearing (4) are designed to radially support a rotor (1) in the stator (2), and
a rotor (1) is inserted into the stator (2) which forms a first bearing surface (10) at a radius R1 in the region of the first pneumatic bearing (3) on a circular-cylindrical section (6) of the rotor (1), and which forms a second bearing surface (13) at a radius R2 in the region of the second pneumatic bearing (4).

15. The probe head arrangement (200) according to claim 2 or any one of the claims 2 to 14 when dependent on claim 2, **characterized in that** a third pneumatic bearing (5) is formed in one of the bearing bases (17, 18), in particular in the second bearing base (18), by means of which a rotor (1) arranged in the stator (2) can be held axially, particularly wherein the rotor (1) has a third bearing surface (14) oriented perpendicular to the axis of rotation (RA).

16. The probe head arrangement (200) according to claim 15, **characterized in that** a counter bearing (35) is also formed in the other bearing base (17, 18), in particular in the first bearing base (17), by means of which the rotor (1) arranged in the stator (2) can be additionally held axially.

17. Use of a probe head arrangement (200) according to one of the preceding claims, for the measuring a measurement substance (40) loaded in a rotor (1), in an MAS NMR experiment, wherein the rotor (1) is arranged in the stator (2), the stator (2) is inserted into the stator bearing (41) and fixed, and the rotor (1) rotates about the axis of rotation (RA), preferably at a frequency of at least 1 kHz, and with particular preference at a frequency of at least 10 kHz.

## Revendications

1. Ensemble tête de mesure RMN-MAS (200), comprenant un stator (2) aligné sur un axe de rotation (RA) pour supporter un rotor (1) avec une substance de mesure (40), un support de stator (32) et un ensemble bobine HF (21) pour émettre des impulsions HF dans la substance de mesure (40) dans le rotor (1) et/ou pour recevoir des signaux HF de la substance de mesure (40) dans le rotor (1), le stator (2) passant à travers l'ensemble bobine HF (21) à l'état inséré,
**caractérisé en ce**
**que** le support de stator (32) est formé avec un palier de stator (41) dans lequel le stator (2) peut être inséré et dont il peut être retiré axialement,
le stator (2) pouvant être passé à travers l'ensemble bobine HF (21) pour l'insertion et le retrait,
et l'ensemble tête de mesure (200) comprenant des moyens avec lesquels le stator (2) peut être fixé axialement de manière temporaire dans le palier de stator (41) à l'état inséré,
et **que** le support de stator (32) forme une butée axiale (32b) qui définit une position rentrée axialement maximale du stator (2) dans le support de stator (32).

2. Ensemble tête de mesure (200) selon la revendication 1, **caractérisé en ce que** le stator (2) comprend une première base de palier (17), un élément d'enveloppe (16) et une deuxième base de palier (18), l'élément d'enveloppe (16) reliant axialement la première base de palier (17) et la deuxième base de palier (18), et la première base de palier (17) formant un premier palier pneumatique (3) et la deuxième base de palier (18) formant un deuxième palier pneumatique (4), que ladite deuxième base de palier (18) présente un diamètre extérieur le plus grand AD2,
que l'élément d'enveloppe (16) présente une partie avant (19) qui se raccorde axialement à la deuxième base de palier (18) et présente un diamètre extérieur le plus grand ADV,
que l'ensemble bobine HF (21) présente un diamètre intérieur le plus petit IDS, et que AD2 < IDS et en outre ADV < IDS.

3. Ensemble tête de mesure (200) selon la revendication 2, **caractérisé en ce que** la première base de palier (17) et/ou l'élément d'enveloppe (16) dans la zone de la première base de palier (17) présente un diamètre extérieur le plus grand AD1, et que AD1 > IDS.

4. Ensemble tête de mesure (200) selon la revendication 2 ou 3, **caractérisé en ce que** le support de stator (32) présente un premier joint (31) avec lequel la première base de palier (17) et/ou l'élément d'enveloppe (16) sont rendus étanche aux gaz par rapport au support de stator (32) dans la zone de la première base de palier (17).

5. Ensemble tête de mesure (200) selon l'une des revendications 2 à 4, **caractérisé en ce que** le support de stator (32) présente un deuxième joint (30) avec lequel la deuxième base de palier (18) et/ou l'élément d'enveloppe (16) sont rendus étanche aux gaz par rapport au support de stator (32) dans la zone de la deuxième base de palier (18).

6. Ensemble tête de mesure (200) selon l'une des revendications 2 à 5, **caractérisé en ce que** l'élément d'enveloppe (16) est conçu étanche aux gaz.

7. Ensemble tête de mesure (200) selon l'une des revendications 2 à 6, **caractérisé en ce que** l'ensemble tête de mesure (200), à l'état inséré du stator (2), forme un espace étanche aux gaz (33) qui est également délimité par l'élément d'enveloppe (16) et dans lequel l'ensemble bobine HF (21) est disposé.

8. Ensemble tête de mesure (200) selon la revendication 7, **caractérisé en ce que** l'espace étanche aux gaz (33) est mis au vide.

9. Ensemble tête de mesure (200) selon la revendication 7 ou 8, **caractérisé en ce que** l'ensemble bobine HF (21) est refroidi à une température cryogénique T dans l'espace étanche aux gaz (33), de préférence avec T ≤ 100 K, particulièrement de préférence avec T ≤ 40 K ou T ≤ 20 K.

10. Ensemble tête de mesure (200) selon la revendication 7 ou 8, **caractérisé en ce qu'**un espace (69) entourant le rotor (1), en particulier à l'intérieur du stator (2), est refroidi à une température cryogénique T_{R}, de préférence avec T_{R} ≤ 100 K, particulièrement de préférence avec T_{R} ≤ 40 K ou T_{R} ≤ 20 K.

11. Ensemble tête de mesure (200) selon l'une des revendications précédentes, **caractérisé en ce que** les moyens avec lesquels le stator (2) peut être fixé axialement dans le palier de stator (41) à l'état inséré comprennent une pièce de fixation mobile ou amovible (43 ; 50) qui, dans une position de fixation, s'engage axialement derrière le stator (2), en particulier la pièce de fixation mobile ou amovible (43 ; 50) s'engageant sur le stator (2) dans la zone de la première base de palier (17).

12. Ensemble tête de mesure (200) selon l'une des revendications précédentes, **caractérisé en ce que** les moyens avec lesquels le stator (2) peut être fixé axialement dans le palier de stator (41) à l'état inséré comprennent au moins une pièce de fixation fixe (61), la pièce de fixation fixe (61) étant formée avec un élément élastique (44) qui, à l'état inséré du stator (2), exerce une pression dans la direction radiale (RR) sur le stator (2),
en particulier deux pièces de fixation fixes (61) étant prévues, qui sont réalisées sous la forme de bagues d'étanchéité (31, 30).

13. Ensemble tête de mesure (200) selon l'une des revendications précédentes, **caractérisé en ce que** la butée axiale (32b) coopère avec un épaulement (42) du stator (2) qui est formé par la première base de palier (17) ou l'élément d'enveloppe (16) dans une zone qui entoure la première base de palier (17).

14. Ensemble tête de mesure (200) selon la revendication 2 ou selon l'une des revendications 3 à 13 si elle se réfère à la revendication 2, **caractérisé en ce que** le premier palier pneumatique (3) et le deuxième palier pneumatique (4) sont conçus pour supporter radialement un rotor (1) dans le stator (2),
et qu'un rotor (1) est inséré dans le stator (2), qui forme une première surface de support (10) de rayon R1 dans la zone du premier palier pneumatique (3) sur une partie cylindrique circulaire (6) du rotor (1), et qui forme une deuxième surface de support (13) de rayon R2 dans la zone du deuxième palier pneumatique (4).

15. Ensemble tête de mesure (200) selon la revendication 2 ou selon l'une des revendications 2 à 14 si elle se réfère à la revendication 2, **caractérisé en ce que** dans l'une des bases de palier (17, 18), en particulier dans la deuxième base de palier (18), est en outre formé un troisième palier pneumatique (5) avec lequel un rotor (1) disposé dans le stator (2) peut être maintenu axialement, le rotor (1) présentant en particulier une troisième surface de support (14) orientée perpendiculairement à l'axe de rotation (RA).

16. Ensemble tête de mesure (200) selon la revendication 15, **caractérisé en ce que** dans l'autre des bases de palier (17, 18), en particulier dans la première base de palier (17), est formé en outre un contre-palier (35) avec lequel le rotor (1) disposé dans le stator (2) peut être maintenu en plus axialement.

17. Utilisation d'un ensemble tête de mesure (200) selon l'une des revendications précédentes pour mesurer une substance de mesure (40) qui est introduite dans un rotor (1) dans une expérience de RMN MAS, le rotor (1) étant disposé dans le stator (2), le stator (2) étant inséré et fixé dans le palier de stator (41) et le rotor (1) tournant autour de l'axe de rotation (RA), de préférence à une fréquence d'au moins 1 kHz et particulièrement de préférence à une fréquence d'au moins 10 kHz.
